# EUROPEAN PATENT APPLICATION

(11) **EP 1 773 106 A2**
(43) Date of publication of application: **11.04.2007**
(21) Application number: 06121750.1
(22) Date of filing: 04.10.2006
(51) Int. Cl.: H05K 5/00, G06F 1/16

(54) **Chassis boss assembly and display apparatus including the same**

(30) Priority: 05.10.2005 KR 20050093325
(71) Applicant: Samsung SDI Co., Ltd., Suwon-si, Gyeonggi-do (KR)
(72) Inventor: Shin, Dong-Hyok, Legal & IP Team, Kiheung-gu, Yongin-si, Kyunggi-do (KR)
(74) Representative: Read, Matthew Charles

(57) **Abstract**

A chassis boss assembly (70), in which a reinforcing member unit (72) and a chassis base (60) are directly coupled to each other, and a plasma display apparatus including the chassis boss assembly, include a boss unit (71) having a recess (71a) and a reinforcing member unit (72) on a lower portion of the boss unit. The chassis boss assembly reduces a number of elements needed as compared to the conventional chassis boss assembly, simplifies fabrication processes, and increases the coupling strength of the boss.

## Description

The present invention relates to a chassis boss assembly and a display apparatus including the same.

Flat panel displays such as plasma display devices are well known for displaying images. In particular, plasma display devices can provide a large screen with superior characteristics in terms of image quality, thickness, weight, and range of the viewing angle.

A plasma display device typically includes a chassis base which supports both a display panel and a circuit board. In addition, the chassis base is coupled to a front case and a rear case of the plasma display apparatus.

In order to couple the circuit board or the case to the chassis base, bosses are coupled to the chassis base or coupled to a reinforcing member that is coupled to the chassis base, and the circuit board or the case is coupled to the chassis base using screws or some other type of fastening device.

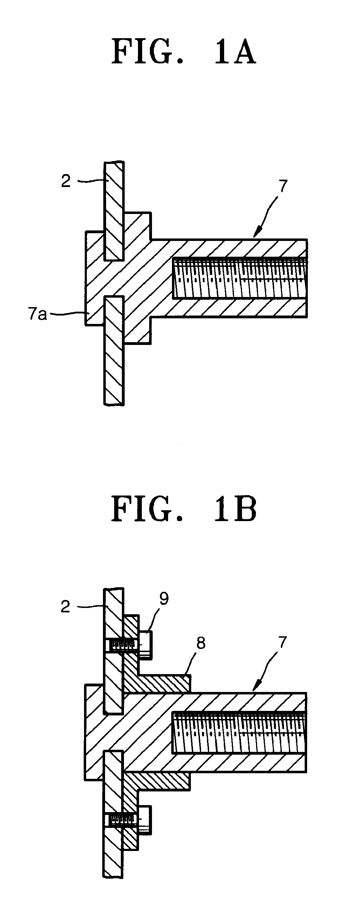

Figure 1A is a schematic view of a boss which supports a case, where the case is bonded to the reinforcing member using a spinning method according to the conventional art.

The boss 7 is coupled to the reinforcing member 2, and a coupled portion between the boss 7 and the reinforcing member 2 is bonded by a spinning process which forms a spinning portion 7a. More specifically, in order to couple the boss 7 to the reinforcing member 2, a penetration hole is formed on the reinforcing member 2 and an end of the boss 7 is inserted into the penetration hole. After the end of the boss 7 is inserted into the penetration hole, the protruding portion of the boss 7 is spin-processed. Then, the protruding portion of the boss 7 is spread onto the reinforcing member 2, and is coupled to the reinforcing member 2. After that, the reinforcing member 2, on which the boss 7 is now bonded, is coupled to a portion of the chassis base (not shown).

However, when the boss 7 is coupled to the reinforcing member 2 by the spinning process according to the conventional art, the strength of the end portion 7a of the boss 7 which is projected through the reinforcing member 2 is very weak after the end portion 7a has been spread by the spinning process. Thus, the end portion 7a may be damaged in certain situations, such as during reliability tests, and therefore may result in damage to the display apparatus.

In order to prevent the boss 7 from escaping out of the reinforcing member 2, a reinforcing cap 8 is formed on an outer circumferential surface of the boss 7. The outer circumferential surface of the boss 7 is coupled to the reinforcing member 2, as shown in Figure 1B, and the reinforcing member 2 is fixedly coupled to the reinforcing cap 8, in order to increase the coupling strength between the boss 7 and the reinforcing member 2.

However, in order to form the reinforcing cap 8 used in the above structure, an additional deep drawing process needs to be performed, making the process for manufacturing and assembling the chassis base complex. Additionally, the above structure requires additional components, including the reinforcing cap 8 and the coupling unit 9.

Aspects of the present invention provide a chassis boss assembly including a boss unit having a recess therein and a reinforcing member unit extending from a lower portion of the boss unit perpendicular to the lower portion and integrally formed with the boss unit, with the reinforcing member unit directly coupled to the chassis base, and a plasma display apparatus including the chassis boss assembly.

According to an aspect of the present invention, a chassis boss assembly includes a chassis base, a boss unit including a recess, a reinforcing member unit which extends from an end portion of the boss unit in a perpendicular direction to the boss unit to support the boss unit fixed onto the chassis base and to reinforce the strength of the chassis base, and a coupling unit which couples the reinforcing member unit to the chassis base.

According to another aspect of the present invention, a plasma display apparatus includes a plasma display panel which displays images using a gas discharge, a chassis base coupled to the plasma display panel which supports the plasma display panel, a boss unit having a recess, a reinforcing member unit which extends from an end portion of the boss unit in a perpendicular direction to the boss unit to support the boss unit fixed onto the chassis base and to reinforce the strength of the chassis base, and a coupling unit which couples the reinforcing member unit to the chassis base.

According to another aspect of the present invention, a coupling unit may be designed to have a strong coupling force by placing a first tool having a protruding portion on a surface of the chassis base where the chassis base and the reinforcing member overlap with each other, and then by placing a second tool having an opening on a surface of the reinforcing member corresponding to the protruding portion of the first tool, and then by pressing the overlapping portion of the chassis base and the reinforcing member against the opening of the second tool by the protruding portion of the first tool.

According to another aspect of the present invention, screws may be used to couple the coupling unit to the reinforcing member unit and the chassis base. The coupling unit may be formed by using a spot welding method, a laser welding method, or a riveting method.

Screw threads may be formed on the inner recess of the boss unit.

Additional aspects and/or advantages of the invention will become evident from the description which follows and, in part, will be apparent from the description, or may be learned by practice of the invention.

These and/or other aspects and advantages of the invention will become apparent and more readily appreciated from the following description of the embodiments, taken in conjunction with the accompanying drawings of which:
Figures 1A and 1B are cross-sectional views of a boss which supports a case according to the conventional art;
Figure 2 is a perspective view of a plasma display device including a chassis boss assembly according to an embodiment of the present invention;
Figure 3 is a perspective view of a chassis boss assembly according to an embodiment of the present invention;
Figure 4 is a cross-sectional view of the chassis boss assembly shown in Figure 3;
Figures 5A and 5B are views illustrating a coupling process which couples a chassis base to a reinforcing member unit in a chassis base assembly, according to an embodiment of the present invention; and
Figure 6 is a view illustrating a coupling process which couples a chassis base to a reinforcing member unit in a chassis boss assembly according to another embodiment of the present invention.

Reference will now be made in detail to the present embodiments of the present invention, examples of which are illustrated in the accompanying drawings, wherein like reference numerals refer to the like elements throughout.

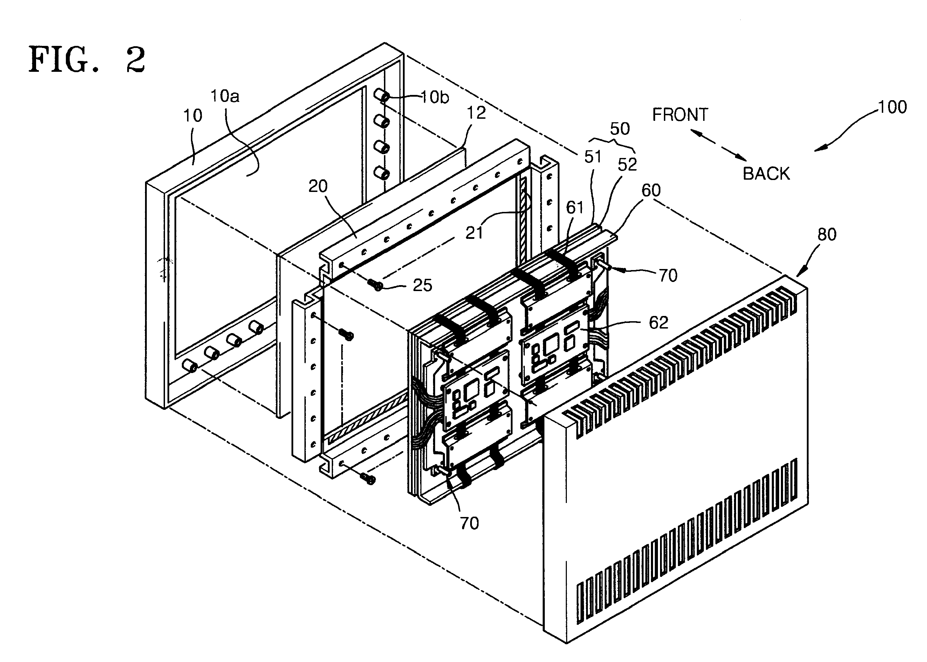

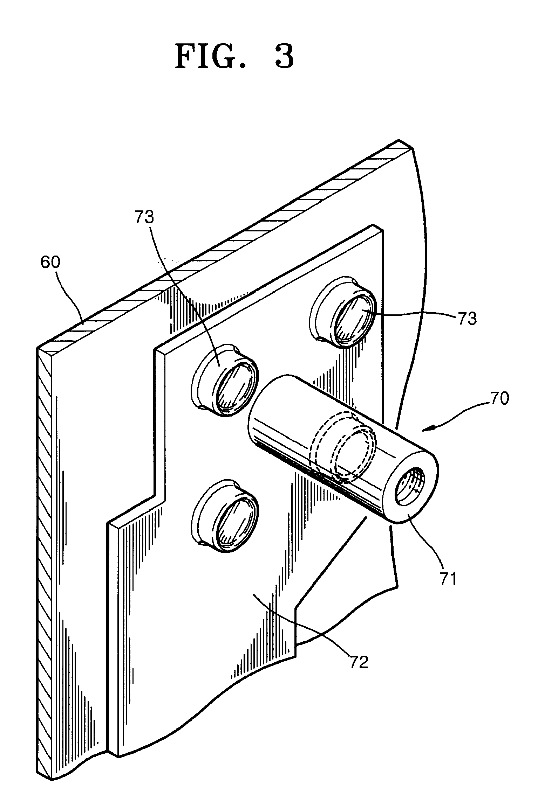

Referring to Figure 2, a plasma display device 100 includes a front case 10 including a window 10a on a center portion thereof, an electromagnetic wave shielding filter 12 disposed on a rear portion of the front case 10 to cover the window 10a, a filter holder 20 which fixes the electromagnetic wave shielding filter 12 onto a peripheral portion of the front case 10, a display panel 50 disposed on a rear portion of the filter holder 20 and including a front substrate 51 and a rear substrate 52, a chassis base 60 which supports the display panel 50, a driving circuit board 62 disposed on a rear portion of the chassis base 60 which drives the display panel 50, a rear case 80 disposed on the driving circuit board 62 and coupled to the front case 10. A chassis boss assembly 70 is mounted on the chassis base 60. The chassis boss assembly is shown in more detail in Figure 3 and includes a boss unit 71 having a recess, a reinforcing member unit 72 which extends from an end of the boss unit 71 in a perpendicular direction to the boss unit 71 to support the boss unit 71 fixed onto the chassis base 60 and reinforce the strength of the chassis base 60, and a coupling portion 73 which couples the reinforcing member unit 72 to the chassis base 60.

A process of assembling the plasma display device will be now described in more detail. The electromagnetic wave shielding filter 12 is clamped onto a rear surface of the front case 10 by means of screws 25 that are fitted through holes the filter holder 20, and screwed into the coupling portions 10b on the front case 10. The display panel 50 is fixed onto a sponge 21 which is attached onto a rear surface of the filter holder 20. Additionally, the driving circuit board 62 which drives the display panel 50 is connected to the display panel 50 by an electric connection unit 61, for example, a tape carrier package (TCP). It is understood that electric connection units other than the TCP may also be used.

Individual chassis boss assemblies 70 are located on both sides of and within a center portion of the chassis base 60 in this embodiment, although the coupling position of the chassis boss assembly 70 can be varied in different devices. The chassis boss assembly 70 reinforces the rigidity of the chassis base 60. Additionally, coupling screws (not shown) fix the chassis base 60 and the rear case 80 to each other by penetrating through the rear case 80 into respective ones of the boss units 71 of the chassis boss assemblies 70.

Instead of coupling screws, a hook or some other type of fastener may instead be used to couple the chassis base 60 to the rear case 80, so that the display device 100 may be hung or fastened onto a wall or other surface.

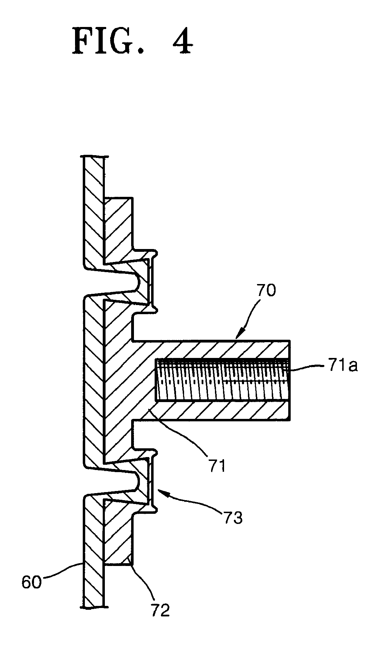

Referring to Figures 3 and 4, the chassis boss assembly 70 includes the chassis base 60, the boss unit 71, the reinforcing member 72, and a chassis coupling unit 73. As shown in Figures 3 and 4, the boss unit 71 according to an embodiment of the present invention is cylindrically shaped. It is understood that the boss unit 71 is not limited to a cylindrical shape, and may instead be a wide variety of different shapes.

Screw threads 71a may be formed on an upper inner portion of the boss unit 71. The screw threads 71a may be formed by directly tapping the boss unit 71, or a nut (not shown), which has been tap-processed, may be inserted into the boss unit 71. However, the screw threads 71a do not need to be present in the boss unit 71. The boss unit 71 may instead have, for example, a recess formed on the upper inner portion of the boss unit 71 which engages a hook. If a hook protruding from a wall is inserted into the boss unit 71 to hang the display apparatus 100 on a wall, the hook may penetrate through the rear case 80 and protrude up into the recess formed on the upper inner portion of the boss unit 71 to hold the display apparatus 100 on the wall.

The reinforcing member unit 72 extends from a lower portion of the boss unit 71 in a perpendicular direction to the outer surface area of the boss unit 71, as shown in Figure 4. The reinforcing member unit 72 is integrally formed with the lower portion of the boss unit 71 in order to support the boss unit 71 which is fixed onto the chassis base 60, and also to reinforce the rigidity of the chassis base 60. The reinforcing member unit 72 can be formed in a variety of shapes depending on a configuration of the circuit board 62.

The reinforcing member unit 72 includes a plurality of coupling units 73 bonded to a corresponding plurality of portions formed on the chassis base 60. The number of reinforcing member units 72 and corresponding coupling units 73 may be adjusted based on the available surface area and/or the shape of the cross-section of the reinforcing member unit 72 which contacts the chassis base 60.

The chassis base 60 and the reinforcing member unit 72 may be coupled to each other using various methods.

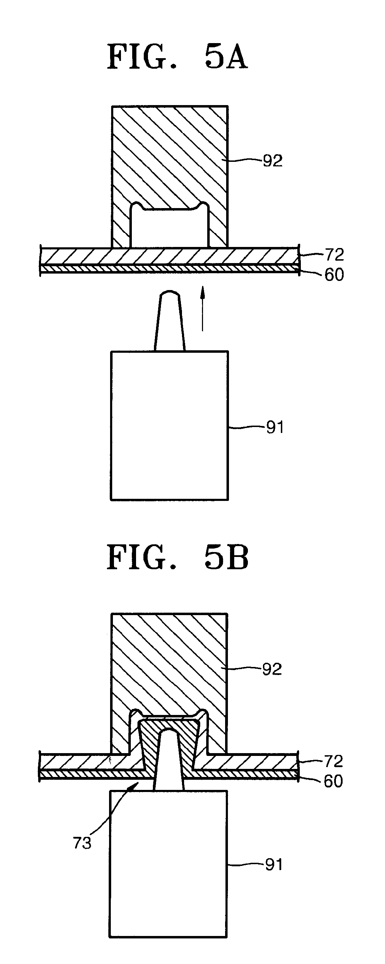

Figures 5A and 5B illustrate an example of a coupling method which couples the reinforcing member unit 72 to the chassis base 60 according to an embodiment of the present invention. Referring to Figures 5A and 5B, on a portion where the surface of the chassis base 60 contacts the surface of the reinforcing member unit 72, a first tool 91 which has a protruding portion is disposed on the side closer to the chassis base 60, and a second tool 92 which has an opening is disposed on the side closer to the reinforcing member unit 72 to correspond to the protruding portion of the first tool 91. Then, the first and second tools 91 and 92 are compressed into each other.

Once the first and second tools 91 and 92 are driven into each other, a part of the overlapping portion of the chassis base 60, along with the reinforcing member unit 72, which is pushed by the protruding portion of the first tool 91, protrude into the opening of the second tool 92, and thus, the coupling unit 73 shown in Figure 5B is formed. This method generates coupling forces in directions perpendicular as well as parallel to the overlapping surface area of the chassis base 60 and the reinforcing unit 72, since the protruding portion of the chassis base 60 locks into the opening of the reinforcing member unit 72 and expands inside the opening.

The coupling method described above and illustrated in Figures 5A and 5B is suitable for a chassis boss assembly 70 and chassis base 60 formed out of metal. However, it is understood that this coupling method may also be used with a chassis boss assembly 70 and chassis base 60 which are not formed out of metal. For example, the chassis boss assembly and chassis base 60 may be formed out of plastic instead. In addition, the thickness of the reinforcing member unit 72 in the chassis boss assembly 70 may be about 2mm or thinner. It is understood, however, that the thickness of the reinforcing member unit 72 may also be more than 2 mm.

Since the coupling unit 73 is formed on the reinforcing member unit 72 that supports the boss unit 71 on the chassis base 60, the method described above and illustrated in Figures 5A and 5B increases the coupling force between the reinforcing member unit 72 and chassis base 60, as compared to the coupling force created by conventional spinning method, which concentrates unnecessary stress on the boss and the reinforcing member unit 72. In addition, since the chassis boss assembly 70 is directly bonded to the chassis base 60, the number of components is reduced and the fabrication process is simplified as compared to the conventional coupling method which uses an additional bracket, a reinforcing cap, and/or a coupling device.

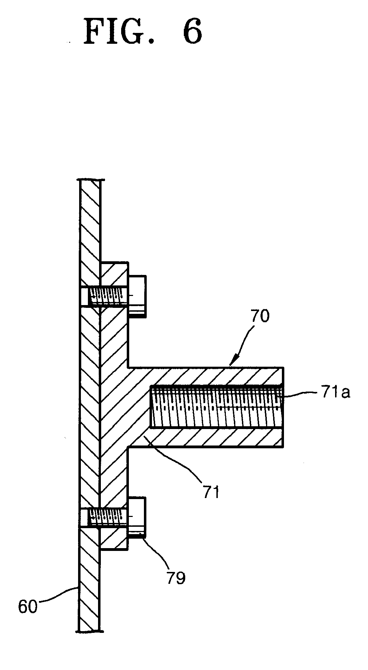

The chassis base 60 and the reinforcing member unit 72 in the chassis boss assembly according to another embodiment of the present invention are coupled to each other with coupling members, such as screws 79, as shown in Figure 6. It is understood that the coupling members are not limited to the screws 79, and may instead by many other types of fasteners. For example, although a rivet joint is not shown in the drawings, a rivet joint may be used to couple the chassis base 60 and the reinforcing member unit 72. Furthermore, although a spot welding process is not illustrated, a spot welding process can be used to form the coupling unit 73. The spot welding process is a kind of resistance welding process. In the spot welding process, electrodes (not shown) are placed into contact with surfaces of two metals that contact each other. Then, a predetermined level of current is supplied to the electrodes, which generates heat on the contacting surfaces, causing welding to occur between the two metals.

The rivet joint, the screw, and the spot welding process are all already well known to those who are skilled in the art, and thus, detailed descriptions of the rivet joint, the screw, and the spot welding process are omitted.

The chassis boss assembly 70 according to aspects of the present invention may be used not only with a plasma display apparatus, but also may be used with any type of flat panel display apparatus which uses bosses to support a case onto a chassis base that supports a circuit board. Additionally, the chassis boss assembly according to aspects of the present invention works with a display apparatus hung onto a wall. It is understood that the chassis base assembly and method according to aspects of the present invention may also work with other types of display apparatuses, and is not limited to flat panel display devices.

According to aspects of the chassis boss assembly and the plasma display device including the chassis boss assembly of the present invention, the boss unit which includes a recess and the reinforcing member unit which extends from the lower portion of the boss unit perpendicular to the boss unit are formed integrally with each other, and the reinforcing member unit and the chassis base are directly coupled to each other.

Therefore, the chassis boss assembly according to aspects of the present invention does not require an additional reinforcing cap, a bracket, and/or a coupling unit as required by the conventional chassis boss assembly. Thus, the chassis boss assembly according to aspects of the present invention reduces the number of components needed and simplifies fabrication process. Additionally, the chassis boss assembly according to aspects of the present invention increases the coupling strength between a boss and a chassis base.

Although a several embodiments of the present invention have been shown and described, it will be appreciated by those skilled in the art that changes may be made in this embodiment without departing from the the invention, the scope of which is defined in the claims.

## Claims

1. A chassis boss assembly, comprising:
a chassis base (60);
a boss unit (70) fixed onto the chassis base;
a reinforcing member unit (72) integrally formed onto the boss unit which contacts the chassis base; and
a coupling unit (73) coupling the reinforcing member unit to the chassis base.

2. The chassis boss assembly of claim 1, wherein the boss unit comprises a cylinder (71) with two ends, and wherein the reinforcing member unit is located at one of the two ends and extends in a direction perpendicular to a surface of the boss unit.

3. The chassis boss assembly of claim 1 or 2, wherein the coupling unit comprises:
an overlap area where the chassis base and the reinforcing member unit contact each other;
a protruding portion of the chassis base which protrudes into the overlap area; and
an opening in the reinforcing member unit which recedes inside the overlap area,
wherein the protruding portion is locked into the opening by expansion inside the opening, to lock the chassis base to the reinforcing member.

4. The chassis boss assembly of claim 1 or 2, wherein the coupling unit comprises coupling members (79) which couple the reinforcing member unit to the chassis base.

5. The chassis boss assembly of claim 4, wherein the coupling members comprise screws (79).

6. The chassis boss assembly of claim 1, wherein the coupling unit is formed using a spot welding method, a laser welding method, or a riveting method.

7. The chassis boss assembly of any preceding claim, wherein screw threads (71a) are formed on an inner recess of the boss unit to engage a screw which couples the chassis base to a rear case of a display apparatus.

8. A flat panel display apparatus, comprising:
a display panel (50) which displays images and a chassis boss assembly as claimed in any preceding claim;
the chassis base (60) being coupled to the display panel, so as to support the display panel;
the boss unit (70) being fixed onto the chassis base;
the reinforcing member unit formed onto the boss unit, being coupled to the chassis base by the coupling unit.

9. The flat panel display apparatus of claim 8 wherein the display panel comprises a plasma display panel.

10. A chassis boss assembly, comprising:
a boss unit;
a chassis base fixed to the boss unit;
a reinforcing member unit formed on the boss unit, which contacts a surface of the chassis base at an overlap area; and
an indentation in the overlap area, which generates coupling forces between the chassis base and the reinforcing member unit.

11. The chassis boss assembly of claim 10, wherein the boss unit comprises a cylinder with two ends, and wherein the reinforcing member unit is located at one of the two ends and extends in a direction perpendicular to a surface of the boss unit.

12. The chassis boss assembly of claim 10 or 11, wherein the indentation comprises:
an overlap area where the chassis base and the reinforcing member unit contact each other;
a protruding portion of the chassis base, which protrudes into the overlap area; and
an opening in the reinforcing member unit, which recedes inside the overlap area,
wherein the protruding portion locks into the opening by expanding inside the opening, to lock the chassis base to the reinforcing member.

13. A flat screen display apparatus with a chassis boss assembly, the apparatus comprising:
a chassis base which supports a display panel and/or a circuit board housed inside the flat screen display apparatus, which is coupled to a front and/or rear case of a flat screen display apparatus, and has a flat surface area;
a boss unit which couples the chassis base to the circuit board and/or the front and/or rear case of the flat screen display apparatus, and contacts the flat surface area of the chassis base;
a reinforcing member unit integrally formed onto the boss unit and having a flat surface which contacts the flat surface of the chassis base so that the flat surface areas of the chassis base and the reinforcing member are aligned parallel to each other; and
a coupling unit coupling the reinforcing member unit to the chassis base.

14. The apparatus of claim 13, wherein the coupling unit comprises: a protrusion integrally formed out of the flat surface area of the chassis base which protrudes out of the flat surface area of the chassis base in a direction towards the flat surface area of the reinforcing member unit, and
a recess integrally formed out of the flat surface area of the reinforcing member unit which recedes in a direction away from the flat surface area of the chassis base and receives the protrusion,
wherein the protrusion is formed to expand inside the recess and lock the protrusion inside the recess.
